(19) **Europäisches Patentamt**
European Patent Office
Office européen des brevets

(11) **EP 1 030 452 B1**

(12) **EUROPÄISCHE PATENTSCHRIFT**

(45) Veröffentlichungstag und Bekanntmachung des Hinweises auf die Patenterteilung:
**16.04.2008 Patentblatt 2008/16**

(51) Int Cl.:
*H03L 7/187* *(2006.01)*     *H03L 7/189* *(2006.01)*

(21) Anmeldenummer: **00103071.7**

(22) Anmeldetag: **15.02.2000**

(54) **Phasenregelkreis**

Phase locked loop

Boucle à verrouillage de phase

(84) Benannte Vertragsstaaten:
**DE FR GB IT**

(30) Priorität: **17.02.1999 DE 19906561**

(43) Veröffentlichungstag der Anmeldung:
**23.08.2000 Patentblatt 2000/34**

(73) Patentinhaber: **Aastra DeTeWe GmbH**
**10997 Berlin (DE)**

(72) Erfinder: **Eckardt, Holger**
**81737 München (DE)**

(74) Vertreter: **Fischer, Uwe**
**Patentanwalt**
**Moritzstrasse 22**
**13597 Berlin (DE)**

(56) Entgegenhaltungen:
EP-A- 0 471 502          DE-A- 19 653 134
US-A- 5 761 258

• **TARUSAWA Y ET AL: "DIGITAL LOOP-PRESET SYNTHESIZER (DLPS) FOR HIGH-SPEED FREQUENCY SWITCHING" ELECTRONICS & COMMUNICATIONS IN JAPAN, PART I - COMMUNICATIONS, SCRIPTA TECHNICA. NEW YORK, US, Bd. 76, Nr. 9, 1. September 1993 (1993-09-01), Seiten 44-54, XP000449116 ISSN: 8756-6621**

**Beschreibung**

Die Erfindung betrifft im allgemeinen das Gebiet von Kommunikationssystemen und im besonderen Vorrichtungen und Verfahren zur Frequenzerzeugung in drahtlosen Kommunikationssystemen.

Das Gebiet der drahtlosen Kommunikation beinhaltet eine Vielzahl von verschiedenen Anwendungen, beispielsweise Rundfunk, Fernsehen, Punkt-zu-Punkt Funkverbindungen, zellulare Mobiltelefonnetze, schnurlose Telefonanlagen und drahtlose Computernetzwerke (Wireless Local Area Networks, WLANs). Zellurare Mobiltelefonnetze in über 60 Ländern verwenden den GSM- (Global System for Mobile Communications-) Standard. Für schnurlose Telefone wurde 1992 der DECT- (Digital European Cordless Telecommunications-) Standard festgelegt und vom European Telecommunications Standards Institut (ETSI) veröffentlicht. Seit 1993 ist der DECT-Standard in der Europäischen Union vorgeschrieben. Die Mitgliedsstaaten haben das Frequenzband von 1,881 bis 1,897 GHz für DECT-Systeme reserviert. Der DECT-Standard basiert auf einer Vielträger-TDMA- (Time Division Multiple Access-) Technologie. Auf 10 Trägern stehen 24 Zeitschlitze, also 240 Übertragungskanäle, mit einer Übertragungsrate von je 32 KBit/s zur Verfügung.

Die Einrichtungen von Kommunikationssystemen enthalten eine Vielzahl von Dekodereinrichtungen, beispielsweise für PAL- (Phase Alternation Line-) und Stereo-Signale, und Frequenzerzeugungseinrichtungen, beispielsweise Tuner in Rundfunk- und Fernsehgeräten. Diese Einrichtungen enthalten Oszillatoren, die häufig eine phasenverkoppelte Regelschleife (Phase-Locked Loop, PLL), d. h. einen Phasenregelkreis, enthalten. Das Signal des freischwingenden Oszillators ist dabei phasenstarr mit einem Referenzsignal gekoppelt. Der Phasenregelkreis zeichnet sich durch Frequenzstabilität und Signalreinheit aus.

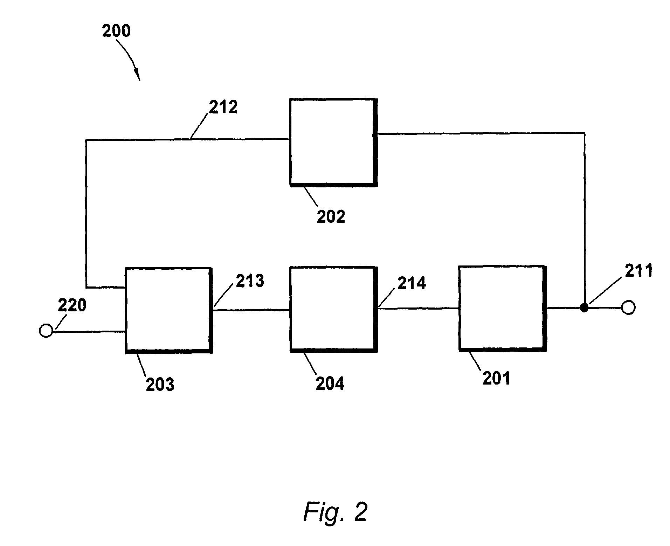

Fig. 2 zeigt einen Phasenregelkreis 200, enthaltend einen steuerbaren Frequenzgenerator 201, eine Rückführungseinrichtung 202, einen Phasendetektor 203 und ein Filter 204. Der Frequenzgenerator 201 ist beispielsweise als spannungsgesteuerter Oszillator (Voltage-Controlled Oscillator, VCO) ausgeführt und liefert ein Ausgangssignal 211, dessen Frequenz von dem am Eingang angelegten Signal 214, beispielweise der angelegten Spannung, abhängig ist. Das Ausgangssignal 211 wird über die Rückführungseinrichtung 202 an den Phasendetektor 203 rückgeführt. Die Rückführungseinrichtung 202 enthält weiterhin einen Frequenzteiler, wobei dessen Teilerverhältnis einstellbar sein kann. Der Phasendetektor 203 bestimmt die Phasendifferenz zwischen dem Rückführungssignal 212 und einem Referenzsignal 220 und erzeugt ein Steuersignal 213. Das Steuersignal 213 am Ausgang des Phasendetektor 203 ist proportional dieser Phasendifferenz. Stimmen die Frequenzen des Rückführungssignals 212 und des Referenzsignals 220 nicht überein, weist das Steuersignal 213, je nach dem Verhältnis der Frequenzen zueinander, eine positive analoge Spannung oder eine negative analoge Spannung auf. In einer anderen Ausführungsform erzeugt der Phasendetektor 203 ein pulsweiten moduliertes digitales Steuersignal 213 mit einer Taktfrequenz, die der Frequenz des Referenzsignals 220 entspricht. Das Tiefpaßfilter 204 wirkt als Integrierglied in dem Regelkreis und unterdrückt ggf. die Frequenz des Referenzsignals 220, um zu verhindern, daß der spannungsgesteuerte Oszillator 201 frequenzmoduliert wird, da dies zu unerwünschten spektralen Anteilen in dem Ausgangssignal 211 führen würde. Das gefilterte Steuersignal 214 steuert den spannungsgesteuerten Oszillator 201 so, daß die Frequenzen des Rückführungssignals 212 und des Referenzsignals 220 schließlich übereinstimmen. Unterschreitet die Phasendifferenz zwischen dem Rückführungssignal 212 und dem Referenzsignal 220 einen bestimmten Wert, ist das Ausgangssignal 211 phasenstarr mit dem Referenzsignal 220 gekoppelt, und der Phasenregelkreis ist "eingerastet".

Eine Änderung der Frequenz des Referenzsignals 220 führt zu einer Änderung der Frequenz des Ausgangssignals 211. Andererseits kann die Frequenz des Ausgangssignals 211 ohne eine Veränderung der Frequenz des Referenzsignals 220 durch Änderung des Teilerverhältnisses des Frequenzteilers 202 erreicht werden. Dabei kann die Frequenz des Ausgangssignals 211 in Frequenzschritten erfolgen, die durch die Frequenz des Referenzsignals 220 bestimmt werden. Wird das Teilerverhältnis um 1 erhöht, erhöht sich die Frequenz des Ausgangssignals 211 um den Betrag der Frequenz des Referenzsignals 220 und umgekehrt. Folglich kann die Frequenz des Ausgangssignals 211 im Raster der Frequenz des Referenzsignals 220 über einen bestimmten Frequenzbereich abgestimmt werden.

Frequenzsynthesizer mit einem Phasenregelkreis weisen eine hohe Frequenzstabilität, Frequenzkonstanz und Signalreinheit auf. Zunehmend werden Oszillatoren mit hoher Frequenzagilität erforderlich, da Kommunikationssysteme Übertragungsverfahren vorsehen, die schnelle Frequenzwechsel erfordern. Der DECT-Standard, beispielsweise, belegt den Frequenzbereich von 1,881 GHz bis 1,897 GHz mit einem Kanalraster von 1,728 MHz, so dass 10 Kanäle entstehen.

Aus der deutschen Offenlegungsschrift 196 53 134 A1 ist eine PLL-Schaltung mit einem Addierglied und einem Schalter bekannt. Der Schalter und das Addierglied ermöglichen es, die PLL-Schaltung in zwei unterschiedlichen Betriebsarten zu betreiben. Die US-Patentschrift 5,761,258 offenbart ebenfalls eine PLL-Schaltung mit einer Umschaltmöglichkeit der Betriebsarten.

Es ist eine Aufgabe der Erfindung, eine Vorrichtung bereitzustellen, die eine Frequenzerzeugung mit hoher Frequenzstabilität und Signalreinheit bei hoher Frequenzagilität ermöglicht.

Diese Aufgabe wird erfindungsgemäß durch einen Phasenregelkreis mit den Merkmalen gemäß Patentanspruch 1 gelöst. Vorteilhafte Ausgestaltungen der Erfindung sind in Unteransprüchen angegeben.

Vorteilhafte Ausgestaltungen und Weiterbildungen der erfindungsgemäßen Vorrichtung werden nachfolgend kurz erläutert; dabei werden zum besseren Verständnis bereits Bezugszeichen angegeben, die sich in den Figuren wiederfinden lassen und weiter unten im Zusammenhang mit der Figurenbeschreibung nochmals erläutert sind.

Es ist eine weitere Aufgabe der Erfindung, ein Verfahren bereitzustellen, das eine Frequenzerzeugung mit hoher Frequenzstabilität und Signalreinheit bei hoher Frequenzagilität ermöglicht.

Diese Aufgabe wird erfindungsgemäß durch ein Verfahren mit den Merkmalen gemäß Patentanspruch 8 gelöst.

Im Folgenden wird eine bevorzugte Ausführungsform der Erfindung unter Bezugnahme auf die beigefügten Zeichnungen näher beschrieben. Es zeigen:

Fig. 1 eine erste, bevorzugte Ausführungsform des Phasenregelkreises gemäß der Erfindung;

Fig. 2 den Phasenregelkreis gemäß dem Stand der Technik;

Fig. 3 eine zweite Ausführungsform des Phasenregelkreises gemäß der Erfindung; und

Fig. 4 eine dritte Ausführungsform des Phasenregelkreises gemäß der Erfindung.

**Detaillierte Beschreibung einer bevorzugten Ausführungsform**

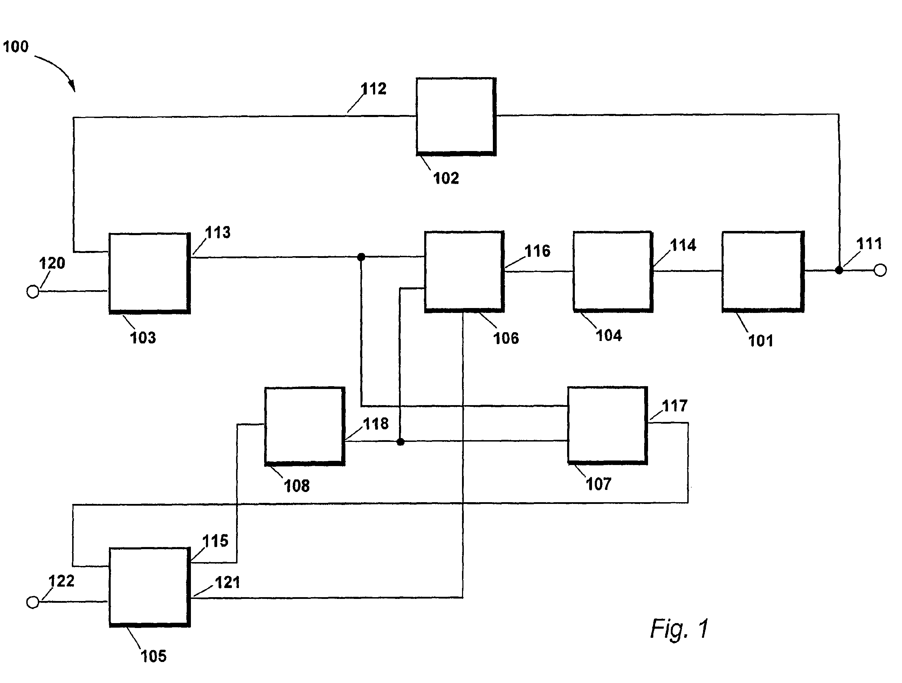

Fig. 1 zeigt eine erste, bevorzugte Ausführungsform des erfindungsgemäßen Phasenregelkreises 100. Der Phasenregelkreis 100 enthält einen steuerbaren Frequenzgenerator 101, eine Rückführungseinrichtung 102, einen Phasendetektor 103, ein Filter 104, eine Steuereinrichtung 105, eine Schalteinrichtung 106, eine Vergleichseinrichtung 107 und einen Digital-Analog-Wandler 108. Der Phasenregelkreis 100 arbeitet als Oszillator und dient in der bevorzugten Ausführungsform als Synthesizer zum Erzeugen eines Ausgangssignals 111 mit einer einstellbaren Frequenz. Neben hoher Frequenzstabilität und Signalreinheit zeichnet sich der erfindungsgemäße Phasenregelkreis 100 durch eine hohe Frequenzagilität aus, d. h. der Phasenregelkreis 100 ist geeignet, schnelle Frequenzwechsel, oder Frequenzsprünge, auszuführen.

In der bevorzugten Ausführungsform ist der steuerbare Frequenzgenerator 101 ein spannungsgesteuerter Oszillator (Voltage-Controlled Oscillator, VCO), d. h. die Frequenz des Ausgangssignals 111 ist abhängig von der Höhe der Spannung 114, die am Eingang des spannungsgesteuerten Oszillators 101 anliegt. Die Rückführungseinrichtung 102 enthält in der bevorzugten Ausführungsform einen Frequenzteiler, der die Frequenz des Ausgangssignals 111 mit einem Teilerverhältnis herunterteilt, das in dieser bevorzugten Ausführungsform einstellbar ist, und stellt ein Rückführungssignal 112 bereit.

Der Phasendetektor 103 vergleicht das Rückführungssignal 112 mit einem Referenzsignal 120 und erzeugt ein erstes Steuersignal 113, das abhängig von der Phasendifferenz zwischen dem Rückführungssignal 112 und dem Referenzsignal 120 ist. Während in der bevorzugten Ausführungsform die Höhe der Spannung des ersten Steuersignals 113 abhängig von dieser Phasendifferenz ist, können Phasendetektoren in anderen Ausführungsformen, beispielsweise, ein Steuersignal 113 als pulsweiten moduliertes Digitalsignal mit einer Taktfrequenz, die der Frequenz des Referenzsignals 120 entspricht, erzeugen. In der bevorzugten Ausführungsform erzeugt der Phasendetektor 103 für sich unterscheidende Frequenzen des Rückführungssignals 112 und des Referenzsignals 120, je nach dem Verhältnis der Frequenzen zueinander, eine positive oder negative Spannung für das erste Steuersignal 113. Sind die Frequenzen des Rückführungssignals 112 und des Referenzsignals 120 gleich, so ist die Spannung des ersten Steuersignals 113 proportional der Phasendifferenz zwischen dem Rückführungssignal 112 und dem Referenzsignal 120. Für einen Bereich, in dem die Frequenzen des Rückführungssignals 112 und des Referenzsignals 120 nahe beieinander liegen, erzeugt der Phasendetektor 103 ein Signal mit der Differenzfrequenz, ähnlich wie ein linearer Mischer.

In der bevorzugten Ausführungsform wird das erste Steuersignal 113 im Regelbetrieb über die Schalteinrichtung 106 als ausgewähltes Steuersignal 116 dem Filter 104 zugeführt, das ein gefiltertes Steuersignal 114 erzeugt, das dem spannungsgesteuerten Oszillator 101 als Eingangssignal zugeführt wird, so daß der Phasenregelkreis geschlossen wird. Das Filter 104 ist ein Tiefpaßfilter (Low-pass Filter, LP), das in dem Phasenregelkreis als Integrierglied wirkt und unerwünschte spektrale Anteile, beispielsweise die Frequenz eines pulsweiten modulierten Digitalsignals, unterdrückt. Das Tiefpaßfilter 104 weist eine Grenzfrequenz auf, die das Regelverhalten des Phasenregelkreises 100 wesentlich beeinflußt. Je höher die Grenzfrequenz ist, um so schneller kann der spannungsgesteuerte Oszillator 101 dem ausgewählten Steuersignal 116, d. h. während des Regelbetriebs dem ersten Steuersignal 113, folgen. Die Höhe der Grenzfrequenz wird weiterhin durch die Anforderungen an die Signalreinheit des Phasenregelkreises 100 bestimmt. Daher kann es vorteilhaft sein, die Frequenz des Referenzsignals 120 möglichst hoch zu wählen und die Frequenz des Ausgangssignals 111 den Erfordernissen entsprechend herunterzuteilen. Die Grenzfrequenz des Tiefpaßfilters 104 ist höher als die maximale Differenz der Frequenz des Rückführungssignals 112 und der Frequenz des Referenzsignals 120, d. h. die maximale Frequenz des ersten Steuersignals 113.

In der bevorzugten Ausführungsform enthält die Steuereinrichtung 105 einen digitalen Prozessor, beispielsweise einen Mikrokontroller, Speicher sowie Ein- und Ausgänge. In anderen Ausführungsformen kann die Steuereinrichtung 105 zusätzliche bzw. andere Einrichtungen enthalten, um die gleichen oder ähnliche Wirkungen zu erreichen oder kann selbst Teil einer Datenverarbeitungseinrichtung sein. In der bevorzugten Ausführungsform erzeugt die Steuereinrichtung 105 digitale zweite Steuersignale 115, die nach Digital-Analog-Wandlung in dem Digital-Analog-Wandler 108 als analoge Signale 118 der Schalteinrichtung 106 zugeführt werden.

Die Steuereinrichtung 105 steuert die Auswahl des ersten Steuersignals 113 oder des zweiten Steuersignals 115 bzw. 118 mit einem Auswahlsignal 121, das der Schalteinrichtung 106 zugeführt wird. Wenn das erste Steuersignal 113 durch die Schalteinrichtung 106 als ausgewähltes Steuersignal 116 dem Tiefpaßfilter 104 zugeführt wird, befindet sich der Phasenregelkreis 100 in dem Regelbetrieb, in dem der Phasenregelkreis 100 in der herkömmlichen Weise arbeitet. Wenn das zweite Steuersignal 115 bzw. 118 durch die Schalteinrichtung 106 als ausgewähltes Steuersignal 116 dem Tiefpaßfilter 104 zugeführt wird, arbeitet der Phasenregelkreis 100 in dem Steuerbetrieb, in dem der Regelkreis geöffnet ist und die Erzeugung des Ausgangssignals 111 mit der Steuereinrichtung 105 gesteuert wird.

Um eine hohe Frequenzagilität zu erreichen, erfolgt die Einstellung eines Ausgangssignals 111 mit einer gewünschten Frequenz zunächst in dem Steuerbetrieb und anschließend in dem Regelbetrieb. Die Steuereinrichtung 105 erzeugt zum einen das zweite Steuersignal 115 bzw. 118 und schaltet zum anderen den Phasenregelkreis 100 mit dem Auswahlsignal 121 zwischen Regelbetrieb und Steuerbetrieb um. Die Erzeugung des zweiten Steuersignals 115 bzw. 118 erfolgt in Abhängigkeit von der gewünschten Frequenz. Die Umschaltung vom Regelbetrieb in den Steuerbetrieb erfolgt zu Beginn des Einstellens eines Ausgangssignals 111 mit einer gewünschten Frequenz, und die Umschaltung von dem Steuerbetrieb in den Regelbetrieb erfolgt in Abhängigkeit eines Schaltsignals 117, das durch die Vergleichseinrichtung 107 durch Vergleichen des ersten Steuersignals 113 und des zweiten Steuersignals 115 erzeugt wird. Der Phasendetektor 103 erzeugt das erste Steuersignal 113 auch während des Steuerbetriebs, so daß eine Umschaltung von dem Steuerbetrieb in den Regelbetrieb ermöglicht wird, nachdem die Differenz zwischen der Spannung des ersten Steuersignals 113 und der Spannung des zweiten Steuersignals 115 bzw. 118 einen vorgegebenen Differenzwert unterschreitet.

Die Umschaltung von dem Steuerbetrieb in den Regelbetrieb erfolgt, wenn die Spannung des ersten Steuersignals 113 und die Spannung des zweiten Steuersignals 115 bzw. 118, innerhalb eines vorgegebenen Bereichs, gleich sind, so daß sich die Umschaltung nicht wesentlich auf das Signal 114 am Eingang des spannungsgesteuerten Oszillators 101 auswirkt. Der vorgegebene Differenzwert wird folglich in der bevorzugten Ausführungsform durch die Grenzfrequenz des Tiefpaßfilters 104 bestimmt.

Für den Betrieb des erfindungsgemäßen Phasenregelkreises 100 werden nach der Inbetriebnahme der Schaltung während eines Regelbetriebs, d. h. der herkömmlichen Betriebsart, verschiedene Frequenzen im vorgesehenen Frequenzbereich nacheinander eingestellt und die jeweiligen Werte des ersten Steuersignal 113 festgestellt. In der bevorzugten Ausführungsform werden die Werte nicht digitalisiert, sondern mit Werten des zweiten Steuersignals 118 verglichen, die die Steuereinrichtung 105 für diesen Zweck erzeugt, d. h. die Funktion eines Analog-Digital-Wandlers wird durch den Digital-Analog-Wandler 108 und die Vergleichseinrichtung 107 erreicht. Andere Ausführungsformen können jedoch, beispielsweise, einen entsprechenden Analog-Digital-Wandler enthalten. Im Speicher der Steuereinrichtung 105 entsteht eine Tabelle (Look-up Table, LUT) mit Frequenz-Spannungspaaren, die für jeden Frequenzwert einen entsprechenden Spannungswert beinhaltet. In anderen Ausführungsformen kann ein Teil der FrequenzSpannungspaare berechnet, d. h. aus anderen Frequenz-Spannungspaaren interpoliert, werden.

Die Einstellung der Frequenz kann in dem Regelbetrieb durch Ändern der Frequenz des Referenzsignals 120, Ändern des Teilerverhältnisses des Frequenzteilers 102 oder einer Kombination davon erfolgen. Die erforderlichen Einstellungen können von der Steuereinrichtung 105 oder einer anderen Einrichtung vorgenommen werden.

Die Erzeugung der Tabelle kann auch nach einem Einschalten des Phasenregelkreises 100 bzw. einer übergeordneten Einheit erfolgen. Weiterhin kann die Tabelle während des Betriebs wiederholt überprüft bzw. erneuert werden. In der bevorzugten Ausführungsform erfolgt diese Erneuerung nach jedem Einrasten. In der bevorzugten Ausführungsform werden darüber hinaus die Frequenz-Spannungspaare für eingestellte Frequenzen regelmäßig während des Regelbetriebs erneuert, ohne daß dafür zusätzliche Zeit erforderlich ist. In einer anderen Ausführungsform erfolgt die Erneuerung in periodischen Zeitabständen.

Wenn während des herkömmlichen Betriebs, d. h. in dem Regelbetrieb, eine gewünschte Frequenz eingestellt werden soll, entnimmt die Steuereinrichtung 105 der Tabelle einen Spannungswert, der einer ausgewählten Frequenz zugeordnet ist, die der gewünschten Frequenz am nächsten kommt. Dabei muß die Differenz zwischen der ausgewählten Frequenz und der gewünschten Frequenz kleiner sein als die Grenzfrequenz des Tiefpaßfilters 104. Die Steuereinrichtung 105 gibt den Spannungswert als digitales zweites Steuersignal 115 an den Digital-Analog-Wandler 108 aus, der das digitale Signal in ein analoges Signal 118 umwandelt. Die Steuereinrichtung 105 schaltet den Phasenregelkreis 100 durch das Auswahlsignal 121, das die Auswahl des ersten Steuersignals 113 oder des zweiten Steuersignals 115 in der Schalteinrichtung 106 steuert, von dem Regelbetrieb in den Steuerbetrieb, so daß das ausgewählte Steuersignal 116 dem zweiten Steuersignal 115, d. h. dem analogen Signal 118, entspricht. Nach einer Zeitdauer, die durch die Grenzfrequenz des Tiefpaßfilters 104 bestimmt wird, erzeugt der spannungsgesteuerte Oszillator 101 ein Ausgangssignal 111 mit einer Frequenz, die im wesentlichen dem Spannungswert der aus der Tabelle ausgewählten Frequenz entspricht.

Obwohl eine dauernde Steuerung des spannungsgesteuerten Oszillators 101 im Steuerbetrieb im Prinzip möglich erscheint, erfolgt im erfindungsgemäßen Phasenregelkreis 100 vorzugsweise eine Umschaltung zurück in den Regelbetrieb, nachdem die Spannung des ersten Steuersignals 113, das durch Vergleich des Rückführungssignals 112 und des Referenzsignals 120 erzeugt wird, und die Spannung des zweiten Steuersignals 115 bzw. 118, das von der Steuereinrichtung 105 erzeugt wird, gleich sind. In der bevorzugten Ausführungsform, die ein Referenzsignal 120 mit einer festen Frequenz verwendet, wird zunächst in der Rückführungseinrichtung 102 ein Teilerverhältnis für den Frequenzteiler eingestellt, das der gewünschten Frequenz zugeordnet ist. In anderen Ausführungsformen könnte, zum Beispiel, für das Referenzsignal 120 eine Frequenz eingestellt werden, die der gewünschten Frequenz zugeordnet ist. Die Vergleichseinrichtung 107 vergleicht die beiden Steuersignale 113 und 115 bzw. 118 und erzeugt ein Schaltsignal 117, wenn die Differenz zwischen der Spannung des ersten Steuersignals 113 und der Spannung des zweiten Steuersignals 115 bzw. 118 einen vorgegebenen Differenzwert unterschreitet. Das Schaltsignal 117 wird der Steuereinrichtung 105 zugeführt, die die Umschaltung in den Regelbetrieb veranlaßt, das zweite Steuersignal 115 bzw. 118 abschaltet und danach ggf. während des Regelbetriebs Werte in der gespeicherten Tabelle erneuert. In anderen Ausführungsformen könnte das Schaltsignal 117 der Schalteinrichtung 106 direkt zugeführt werden; eine logische Verknüpfung des Auswahlsignals 121 und des Schaltsignals 117 könnte in der Schalteinrichtung 106 erfolgen.

In dem Regelbetrieb gleicht der Phasenregelkreis 100 die Differenz zwischen der Spannung des zweiten Steuersignals 115 bzw. 118 und der Spannung des ersten Steuersignals 113 aus und rastet wie im herkömmlichen Betrieb ein. Der erfindungsgemäße Phasenregelkreis 100 verwirklicht so einen schnellen Frequenzwechsel mit kurzer Einrastzeit. Die kohärente Umschaltung gemäß der Erfindung verhindert, daß die Umschaltung von dem Steuerbetrieb in den Regelbetrieb erfolgt, wenn die Spannung des ersten Steuersignals 113 und die Spannung des zweiten Steuersignals 115 bzw. 118 nicht gleich sind, was dazu führen könnte, daß eine falsche Frequenz eingestellt würde und der Phasenregelkreis 100 neu einrasten müßte. Dies würde zu einer Zeitdauer für einen Frequenzwechsel führen, die länger wäre als für den herkömmlichen Phasenregelkreis 200 gemäß Fig. 2.

Der Phasendetektor 103 bestimmt aus dem Rückführungssignal 112 und dem Referenzsignal 120 das erste Steuersignal 113:

$$u_{113}(t) = K \times \theta(t) \tag{1}$$

wobei K der Verstärkungsfaktor des Phasendetektors 103 ist und $\theta$ die Phasendifferenz zwischen den beiden Signalen 112 und 120 ist.

Die beiden Signale 112 und 120 sind periodische Signale mit beliebiger Kurvenform und unterschiedlicher Frequenz:

$$u_{112}(t) = g\left(2\pi f_{112} t\right) \tag{2}$$

$$u_{120}(t) = g\left(2\pi f_{120} t\right) \tag{3}$$

Der Phasendetektor 103 betrachtet die Nulldurchgänge der Signalspannungen. Wenn zu einem Zeitpunkt $t_0$ beide Nulldurchgänge erfolgen, ist die Spannung des ersten Steuersignals 113 Null, $u_{113}(0) = 0$. Mit wachsender Zeit akkumuliert sich die Phasendifferenz, und die Spannung $u_{113}(t)$ steigt linear, bis die Phasendifferenz $\theta$ den Wert $2\pi$ erreicht und die Spannung $u_{113}(t)$ auf Null zurückkehrt. Der Spannungsverlauf des ersten Steuersignal 113 ist somit sägezahnförmig, wobei die Frequenz der Differenz der Frequenzen der beiden Signale 112, 120 entspricht:

$$u_{113}(t) = K \times \left| 2\pi\left(f_{112} - f_{120}\right)t \right|_{\mathrm{mod}\,2\pi} \tag{4}$$

Der Phasenregelkreis 100 weist bezüglich der Einschwingzeit zwei unterschiedliche Verhaltensweisen auf.

Bei einem kleinen Frequenzsprung folgt der Phasenregelkreis 100 der Änderung ohne auszurasten, bei größeren Frequenzsprüngen rastet der Phasenregelkreis aus und muß neu einrasten, was eine wesentlich längere Einschwingzeit erfordert.

Je nach Art des verwendeten Phasendetektors 103 kann der maximale Frequenzsprung das 2,5- bis 11-fache der Eigenfrequenz $f_{100}$ des Phasenregelkeises 100 betragen, wenn der Phasenregelkreis 100 nicht ausrasten soll. Die Eigenfrequenz $f_{100}$ des Phasenregelkreises 100 ist proportional zur Grenzfrequenz $f_{104}$ des Tiefpaßfilters 104. Folglich muß die Voreinstellung der Frequenz in dem Steuerbetrieb innerhalb dieses Bereichs um die gewünschte Frequenz erfolgen.

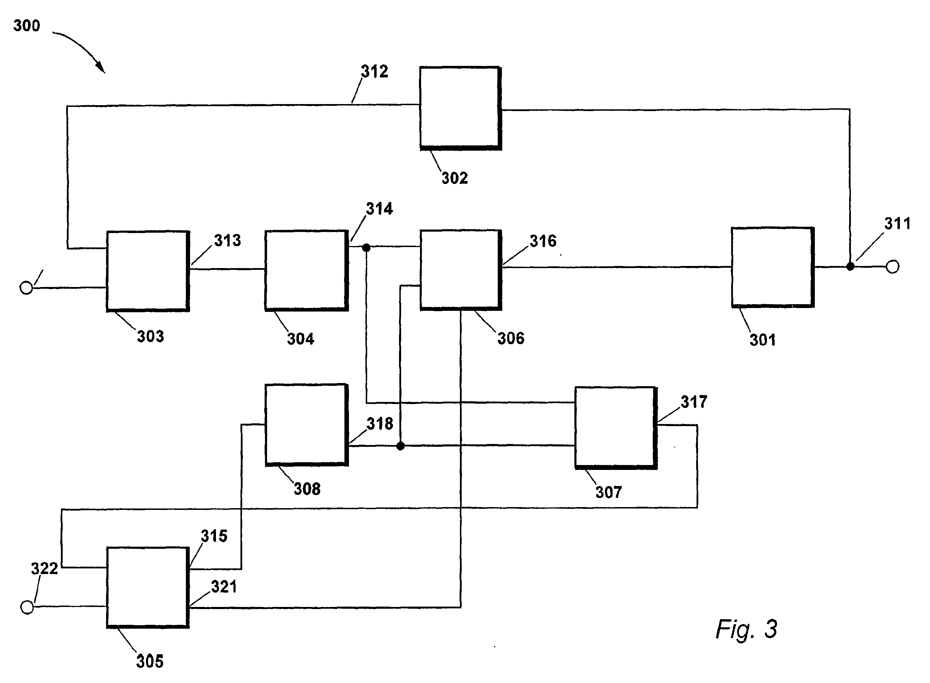

Fig. 3 zeigt eine zweite, alternative Ausführungsform des erfindungsgemäßen Phasenregelkreises 300. Der Phasenregelkreis 300 enthält einen steuerbaren Frequenzgenerator 301, eine Rückführungseinrichtung 302, einen Phasendetektor 303, ein Filter 304, eine Steuereinrichtung 305, eine Schalteinrichtung 306, eine Vergleichseinrichtung 307 und einen Digital-Analog-Wandler 308. Das Filter 304 ist wiederum ein Tiefpaßfilter, das in dem Phasenregelkreis als Integierglied wirkt. Im Unterschied zur ersten Ausführungsform wird in dieser alternativen Ausführungsform dem Filter 304, das das gefilterte Steuersignal 314 erzeugt, das erste Steuersignal 313 zugeführt und der Schalteinrichtung 306 das gefilterte Steuersignal 314 zugeführt. In dem Regelbetrieb wird das gefilterte Steuersignal 314 dem spannungsgesteuerten Oszillator 301 als ausgewähltes Steuersignal 316 zugeführt, so daß der Phasenregelkreis geschlossen ist.

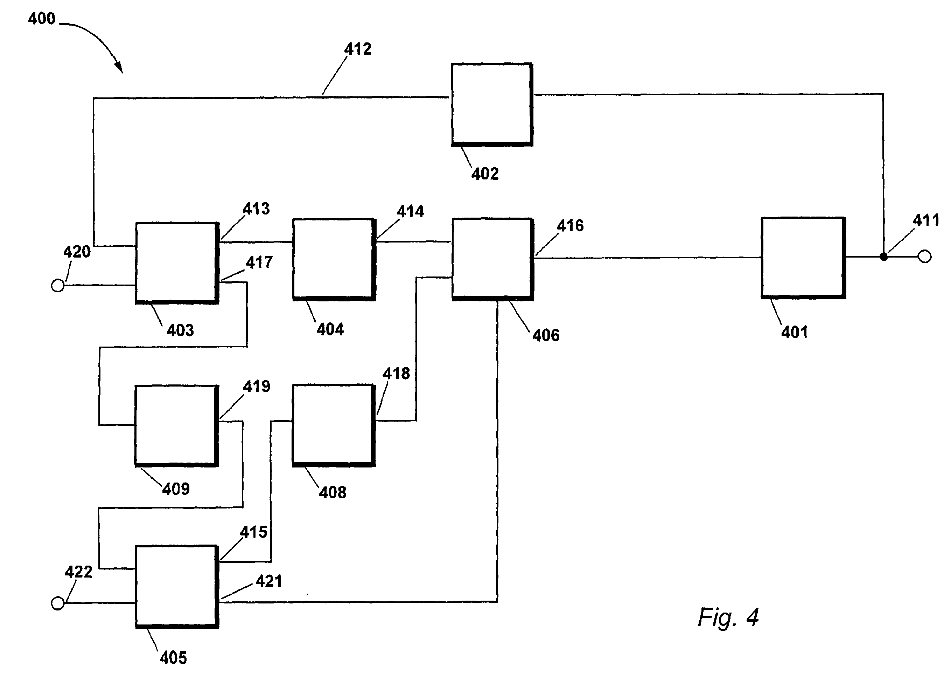

Fig. 4 zeigt eine dritte, alternative Ausführungsform des erfindungsgemäßen Phasenregelkreises 400. Der Phasenregelkreis 400 enthält einen steuerbaren Frequenzgenerator 401, eine Rückführungseinrichtung 402, einen Phasendetektor 403, ein erstes Filter 404, eine Steuereinrichtung 405, eine Schalteinrichtung 406, und einen Digital-Analog-Wandler 408. Weiterhin kann der Phasenregelkreis 400 ein zweites Filter 409 enthalten, das ein Tiefpaßfilter ist. Im Unterschied zur zweiten Ausführungsform wird in dieser alternativen Ausführungsform das Schaltsignal 417 von dem Phasendetektor 403 erzeugt. Das Schaltsignal 417 wird über einen Einrast-Erkennungs-Ausgang (Lock-Detect Output) bereitgestellt. Das Schaltsignal 417 wird bei herkömmlichen Phasendetektoren in der Regel kurz vor dem Einrasten aktiviert. Das Schaltsignal 417 wird zur Erhöhung der Störsicherheit dem Filter 409 zugeführt, das ein gefiltertes Schaltsignal 419 erzeugt. Das gefilterte Schaltsignal 419 wird der Steuereinrichtung 405 zugeführt. Der Vergleich der Spannung des ersten Steuersignals 413 bzw. 414 und der Spannung des zweiten Steuersignals 415 bzw. 418 erfolgt in dieser Ausführungsform auf indirekte Weise. In dem Steuerbetrieb zeigt das Schaltsignal 417 bzw. 419 an, wenn die Differenz zwischen der Spannung des ersten Steuersignals 413 bzw. 414 und der Spannung des zweiten Steuersignals 415 bzw. 418 den vorgegebenen Differenzwert unterschreitet, so daß die Umschaltung von dem Steuerbetrieb in den Regelbetrieb durch die Steuereinrichtung 405 veranlaßt werden kann. In anderen Ausführungsformen könnte das Schaltsignal 417 bzw. 419 wiederum der Schalteinrichtung 406 direkt zugeführt werden; eine logische Verknüpfung des Auswahlsignals 421 und des Schaltsignals 417 bzw. 419 könnte in der Schalteinrichtung 406 erfolgen.

Der erfindungsgemäße Phasenregelkreis 100, 300, 400 eignet sich insbesondere für Mobilfunkgeräte und Basisstationen und hier vorzugsweise für digitale Standards wie, zum Beispiel, DECT und GSM. Gemäß dem DECT-Standard ist das Kanalraster 1,728 MHz. In einem erfindungsgemäßen Phasenregelkreis 100 beträgt beispielsweise die Zeitkonstante des Tiefpaßfilters 104, $T_{104} = 15\ \mu s$, die Eigenfrequenz des Phasenregelkreises 100, $f_{100} = 12$ kHz und die Frequenz des Referenzsignals 120, $f_{120} = 11$ MHz. Bei einem Teilerverhältnis von $n = 1080$ ergibt sich für einen Sprung um einen Kanal $\Delta f_{112} = 10$ kHz. Für einen Frequenzwechsel um fünf Kanäle ist bei einem herkömmlichen Phasenregelkreis eine Zeitdauer von 100 $\mu s$ erforderlich bis die Frequenz des Ausgangssignals 111 bis auf 10 kHz an die gewünschte Frequenz eingeschwungen ist. Eine Spannungsänderung des ausgewählten Steuersignals 116, die einem Versatz um einen halben Kanal entspricht, wird dagegen in 10 $\mu s$ ausgeregelt. Unter der Annahme, daß das Bereitstellen des zweiten Steuersignals 115 bzw. 118 eine Zeitdauer von 10 $\mu s$ erfordert, kann die Zeitdauer für einen Frequenzwechsel um den Faktor 5 verkürzt werden.

## Patentansprüche

1. Phasenregelkreis (100: 300) zum Erzeugen eines Ausgangssignals (111: 311) mit einer einstellbaren Frequenz, enthaltend:

- einen steuerbaren Frequenzgenerator (101: 301) zum Erzeugen des Ausgangssignals (111: 311) in Abhängigkeit eines ausgewählten Steuersignals (116: 316),
- eine Rückführungseinrichtung (102: 302) zum Rückführen des Ausgangssignals (111: 311) als Rückführungssignal (112: 312),
- einen Phasendetektor (103: 303) zum Erzeugen eines ersten Steuersignals (113: 313) in Abhängigkeit der Phasendifferenz zwischen dem Rückführungssignal (112: 312) und einem Referenzsignal (120: 320),
- eine Steuereinrichtung (105: 305) zum Erzeugen eines zweiten Steuersignals (115, 118: 315, 318) in Abhängigkeit von einer gewünschten Frequenz,

**EP 1 030 452 B1**

- eine Einrichtung (107: 307) zum Erzeugen eines Schaltsignals (117: 317)

**gekennzeichnet durch**

- eine Schalteinrichtung (106: 306) zum Auswählen entweder des ersten Steuersignals (113: 313) oder des zweiten Steuersignals (115, 118: 315, 318) als ausgewähltes Steuersignal (116: 316) in Abhängigkeit eines Auswahlsignals (121: 321),

- wobei die Steuereinrichtung (105: 305) für einen Steuerbetrieb zum Einstellen der gewünschten Frequenz zunächst ein Auswahlsignal (121: 321) an die Schalteinrichtung (106: 306) ausgibt, das die Auswahl des zweiten Steuersignals (115, 118: 315, 318) als ausgewähltes Steuersignal (116: 316) bewirkt und anschließend, nachdem das Schaltsignal (117: 317) erzeugt worden ist, für einen Regelbetrieb ein Auswahlsignal (121: 321) erzeugt, das die Auswahl des ersten Steuersignals (113: 313) als ausgewähltes Steuersignal (116: 316) bewirkt,

- wobei ein Speicher vorhanden ist, in dem eine Tabelle mit Frequenzspannungspaaren abgespeichert ist, die für jeden Frequenzwert eines Frequenzspannungspaares einen entsprechenden Spannungswert beinhaltet,

- wobei im Steuerbetrieb das zweite Steuersignal (115, 118: 315, 318) in Abhängigkeit von der gewünschten Frequenz durch Auslesen der Tabelle mit den Frequenzspannungspaaren gebildet wird,

- wobei die Steuereinrichtung derart ausgestaltet ist, dass sie die Freguenzspannungspaare für eingestellte Frequenzen während des Regelbetriebs in der gespeicherten Tabelle erneuert, und

- wobei die Einrichtung zum Erzeugen des Schaltsignals (117: 317) gebildet ist

- entweder **durch** eine Vergleichseinrichtung (107: 307) zum Vergleichen des ersten Steuersignals (113: 313) und des zweiten Steuersignals (115, 118: 315, 318) und zum Erzeugen des Schaltsignals (117: 317), wenn die Differenz zwischen dem ersten Steuersignal (113: 313) und dem zweiten Steuersignal (115, 118: 315, 318) einen vorgegebenen Differenzwert unterschreitet,

- oder **durch** den Phasendetektor (403), der das Schaltsignal (417) erzeugt, wenn eine Einrast-Bedingung des Phasenregelkreises (400) erkannt wird.

2. Phasenregelkreis nach Anspruch 1, **dadurch gekennzeichnet, dass** die Steuereinrichtung einen digitalen Prozessor, insbesondere einen Mikrokontroller, aufweist.

3. Phasenregelkreis (100) nach Anspruch 1 oder 2, weiterhin enthaltend ein Tiefpassfilter (104) mit einer Grenzfrequenz zum Erzeugen eines gefilterten Steuersignals (114) aus dem ausgewählten Steuersignal (116).

4. Phasenregelkreis (300: 400) nach einem der Ansprüche 1 bis 3, weiterhin enthaltend ein Tiefpassfilter (304: 404) mit einer Grenzfrequenz zum Erzeugen eines gefilterten Steuersignals (314: 414) aus dem ersten Steuersignal (313: 413).

5. PCMCIA- (Personal Computer Memory Card International Association-) Karte zur schnurlosen Datenübertragung, vorzugsweise gemäss dem DECT- (Digital European Cordless Telecommunications-) Standard, mit einem Phasenregelkreis (100: 300: 400) nach einem der Ansprüche 1 bis 4.

6. Basisstation zur schnurlosen Datenübertragung, vorzugsweise gemäss dem DECT-Standard, mit einem Phasenregelkreis (100: 300: 400) nach einem der Ansprüche 1 bis 4.

7. Mobileinheit zur schnurlosen Datenübertragung, vorzugsweise gemäss dem DECT-Standard, mit einem Phasenregelkreis (100: 300: 400) nach einem der Ansprüche 1 bis 4.

8. Verfahren zum Erzeugen eines Ausgangssignals (111: 311) mit einer einstellbaren Frequenz in einem Phasenregelkreis (100: 300), umfassend die Schritte:

- Erzeugen des Ausgangssignals (111: 311) in Abhängigkeit eines ausgewählten Steuersignals (116: 316),

- Rückführen des Ausgangssignals (111: 311) als Rückführungssignal (112: 312),

- Erzeugen eines ersten Steuersignals (113: 313) in Abhängigkeit der Phasendifferenz zwischen dem Rückführungssignal (112: 312) und einem Referenzsignal (120: 320),

- Erzeugen eines zweiten Steuersignals (115, 118: 315, 318) in Abhängigkeit von einer gewünschten Frequenz, und

- Erzeugen eines Schaltsignals (117: 317),

**gekennzeichnet durch** folgende Schritte:

- Auswählen entweder des ersten Steuersignals (113: 313) oder des zweiten Steuersignals (115, 118: 315, 318) als ausgewähltes Steuersignal (116: 316) in Abhängigkeit eines Auswahlsignals (121: 321),

- wobei für einen Steuerbetrieb zum Einstellen der gewünschten Frequenz zunächst ein Auswahlsignal (121: 321) ausgegeben wird, das die Auswahl des zweiten Steuersignals (115, 118: 315, 318) als ausgewähltes Steuersignal (116: 316) bewirkt und anschließend, nachdem das Schaltsignal (117: 317) erzeugt worden ist, für einen Regelbetrieb ein Auswahlsignal (121: 321) erzeugt wird, das die Auswahl des ersten Steuersignals (113: 313) als ausgewähltes Steuersignal (116: 316) bewirkt,

- wobei in einem Speicher eine Tabelle mit Frequenzspannungspaaren derart abgespeichert ist, dass diese für jeden Frequenzwert eines Frequenzspannungspaares einen entsprechenden Spannungswert beinhaltet,

- wobei im Steuerbetrieb das zweite Steuersignal (115, 118: 315, 318) in Abhängigkeit von der gewünschten Frequenz durch Auslesen der Tabelle mit den Frequenzspannungspaeren gebildet wird,

- wobei im Regelbetrieb die Frequenzspannungspaare für eingestellte Frequenzen in der gespeicherten Tabelle erneuert werden und

- wobei das Schaltsignal erzeugt wird, wenn die Differenz zwischen dem ersten Steuersignal (113: 313) und dem zweiten Steuersignal (115, 118: 315, 318) einen vorgegebenen Differenzwert unterschreitet oder wenn eine Einrast-Bedingung des Phasenregelkreises (400) erkannt wird.

## Claims

1. Phase locked loop (100: 300) for generating an output signal (111: 311) at a frequency which can be set, said phase locked loop containing:

   - a controllable frequency generator (101: 301) for generating the output signal (111: 311) on the basis of a selected control signal (116: 316),
   - a feedback device (102: 302) for feeding back the output signal (111: 311) in the form of a feedback signal (112: 312),
   - a phase detector (103: 303) for generating a first control signal (113: 313) on the basis of the phase difference between the feedback signal (112: 312) and a reference signal (120: 320),
   - a control device (105: 305) for generating a second control signal (115, 118: 315, 318) on the basis of a desired frequency,
   - a device (107: 307) for generating a switching signal (117: 317),
   **characterized by**
   - a switching device (106: 306) for selecting either the first control signal (113: 313) or the second control signal (115, 118: 315, 318) as the selected control signal (116: 316) on the basis of a selection signal (121: 321),
   - the control device (105: 305) first of all outputting a selection signal (121: 321) to the switching device (106: 306) for open-loop control for setting the desired frequency, which selection signal causes the second control signal (115, 118: 315, 318) to be selected as the selected control signal (116: 316), and then, after the switching signal (117: 317) has been generated, generating a selection signal (121: 321) for closed-loop control, which selection signal causes the first control signal (113: 313) to be selected as the selected control signal (116: 316),
   - provision being made of a memory which stores a table containing frequency/voltage pairs, which table comprises a corresponding voltage value for each frequency value in a frequency/voltage pair,
   - the second control signal (115, 118: 315, 318) being formed during open-loop control on the basis of the desired frequency by reading the table containing the frequency/voltage pairs,
   - the control device being configured in such a manner that, during closed-loop control, it renews the frequency/voltage pairs in the stored table for frequencies which have been set, and
   - the device for generating the switching signal (117: 317) being formed

     - either by a comparison device (107: 307) for comparing the first control signal (113: 313) and the second control signal (115, 118: 315, 318) and for generating the switching signal (117: 317) if the difference between the first control signal (113: 313) and the second control signal (115, 118: 315, 318) undershoots a predefined difference value,
     - or by the phase detector (403) which generates the switching signal (417) when a locking condition of the phase locked loop (400) is detected.

2. Phase locked loop according to Claim 1, **characterized in that** the control device has a digital processor, in particular a microcontroller.

**3.** Phase locked loop (100) according to Claim 1 or 2, which also contains a low-pass filter (104) with a cut-off frequency for generating a filtered control signal (114) from the selected control signal (116).

**4.** Phase locked loop (300: 400) according to one of Claims 1 to 3, which also contains a low-pass filter (304: 404) with a cut-off frequency for generating a filtered control signal (314: 414) from the first control signal (313: 413).

**5.** PCMCIA (Personal Computer Memory Card International Association) card for wireless data transmission, preferably according to the DECT (Digital European Cordless Telecommunications) standard, having a phase locked loop (100: 300: 400) according to one of Claims 1 to 4.

**6.** Base station for wireless data transmission, preferably according to the DECT standard, having a phase locked loop (100: 300: 400) according to one of Claims 1 to 4.

**7.** Mobile unit for wireless data transmission, preferably according to the DECT standard, having a phase locked loop (100: 300: 400) according to one of Claims 1 to 4.

**8.** Method for generating an output signal (111: 311) at a frequency which can be set in a phase locked loop (100: 300), said method comprising the steps of:

- generating the output signal (111: 311) on the basis of a selected control signal (116: 316),
- feeding back the output signal (111: 311) in the form of a feedback signal (112: 312),
- generating a first control signal (113: 313) on the basis of the phase difference between the feedback signal (112: 312) and a reference signal (120: 320),
- generating a second control signal (115, 118: 315, 318) on the basis of a desired frequency, and
- generating a switching signal (117: 317),

**characterized by** the following steps of:

- selecting either the first control signal (113: 313) or the second control signal (115, 118: 315, 318) as the selected control signal (116: 316) on the basis of a selection signal (121: 321),
- a selection signal (121: 321) first of all being output for open-loop control for setting the desired frequency, which selection signal causes the second control signal (115, 118: 315, 318) to be selected as the selected control signal (116: 316), and then, after the switching signal (117: 317) has been generated, a selection signal (121: 321) being generated for closed-loop control, which selection signal causes the first control signal (113: 313) to be selected as the selected control signal (116: 316),
- a table containing frequency/voltage pairs being stored in a memory in such a manner that it comprises a corresponding voltage value for each frequency value in a frequency/voltage pair,
- the second control signal (115, 118: 315, 318) being formed during open-loop control on the basis of the desired frequency by reading the table containing the frequency/voltage pairs,
- during closed-loop control, the frequency/voltage pairs being renewed in the stored table for frequencies which have been set, and
- the switching signal being generated if the difference between the first control signal (113: 313) and the second control signal (115, 118: 315, 318) undershoots a predefined difference value or if a locking condition of the phase locked loop (400) is detected.

**Revendications**

**1.** Circuit (100 : 300) de régulation de phase qui forme un signal de sortie (111 : 311) à fréquence réglable et qui contient :

- un générateur de fréquences (101 : 301) qui crée le signal de sortie (111 : 311) en fonction d'un signal de commande (116 : 316) sélectionné,
- un dispositif de renvoi (102 : 302) qui renvoie le signal de sortie (111 : 311) comme signal de renvoi (112 : 312),
- un détecteur de phase (103 : 303) qui forme un premier signal de commande (113 : 313) en fonction de la différence de phase entre le signal de renvoi (112 : 312) et un signal de référence (120 : 320),
- un dispositif de commande (105 : 305) qui forme un deuxième signal de commande (115, 118 : 315, 318) en fonction d'une fréquence souhaitée et
- un dispositif (107 : 307) qui forme un signal de commutation (117 : 317),

**caractérisé par**

- un dispositif de commutation (106 : 306) qui sélectionne soit le premier signal de commande (113 : 313) soit le deuxième signal de commande (115, 118 : 315, 318) comme signal de commande sélectionné (116 : 316) en fonction d'un signal de sélection (121 : 321),

- en mode de commande destiné à régler la fréquence souhaitée, le dispositif de commande (105 : 305) délivrant d'abord au dispositif de commutation (106 : 306) un signal de sélection (121 : 321) qui a pour effet la sélection du deuxième signal de commande (115, 118 : 315, 318) comme signal de commande sélectionné (116 : 316), tandis qu'ensuite en mode de régulation après que le signal de commutation (117 : 317) a été formé, il forme un signal de sélection (121 : 321) qui a pour effet la sélection du premier signal de commande (113 : 313) comme signal de commande sélectionné (116 : 316),

- avec une mémoire dans laquelle est conservé un tableau de paires fréquence - tension qui, pour chaque valeur de fréquence d'une paire fréquence - tension contient une valeur de tension correspondante,

- tandis qu'en mode de commande, le deuxième signal de commande (115, 118 : 315, 318) est formé en fonction de la fréquence souhaitée par lecture du tableau qui contient les paires fréquence - tension,

- le dispositif de commande étant configuré de telle sorte que pour les fréquences réglées en mode de régulation, il renouvelle les paires fréquence - tension dans le tableau conservé en mémoire et

- le dispositif de formation du signal de commutation (117 : 317) étant formé

- par un dispositif de comparaison (107 : 307) qui compare le premier signal de commande (113 : 313) et le deuxième signal de commande (115, 118 : 315, 318) et qui forme le signal de commutation (117 : 317) lorsque la différence entre le premier signal de commande (113 : 313) et le deuxième signal de commande (115, 118 : 315, 318) n'atteint pas une valeur de différence prédéterminée,

- ou par le détecteur de phase (403) qui forme le signal de commutation (417) lorsque l'on constate que le circuit (400) de régulation de phase satisfait une condition d'enclenchement.

2. Circuit de régulation de phase selon la revendication 1, **caractérisé en ce que** le dispositif de commande présente un processeur numérique et en particulier un microcontrôleur.

3. Circuit de régulation de phase (100) selon les revendications 1 ou 2, qui contient en outre un filtre passe-bas (104) à fréquence limite qui filtre le signal de commande (116) sélectionné pour former un signal de commande (114) filtré.

4. Circuit (300: 400) de régulation de phase selon l'une des revendications 1 à 3, qui contient en outre un filtre passe-bas (304 : 404) à fréquence limite qui filtre le premier signal de commande (313 : 413) pour former un signal de commande filtré (314 : 414).

5. Carte PCMCIA ("Personal Computer Memory Card International Association") pour le transfert de données sans fil, de préférence conforme à la norme DECT ("Digital European Cordless Telecommunications"), dotée d'un circuit (100 : 300 : 400) de régulation de phase selon l'une des revendications 1 à 4.

6. Poste de base pour le transfert de données sans fil, de préférence selon la norme DECT, qui présente un circuit (100 : 300 : 400) de régulation de phase selon l'une des revendications 1 à 4.

7. Unité mobile de transfert sans fil de données, de préférence selon la norme DECT, qui présente un circuit (100: 300 : 400) de régulation de phase selon l'une des revendications 1 à 4.

8. Procédé de formation d'un signal de sortie (111 : 311) à fréquence réglable dans un circuit (100 : 300) de régulation de phase, ledit procédé comprenant les étapes qui consistent à :

- former le signal de sortie (111 : 311) en fonction d'un signal de commande (116 : 316) sélectionné,
- renvoyer le signal de sortie (111 : 311) comme signal de renvoi (112 : 312),
- former un premier signal de commande (113 : 313) en fonction de la différence de phase entre le signal de renvoi (112 : 312) et un signal de référence (120 : 320),
- former un deuxième signal de commande (115, 118 : 315, 318) en fonction d'une fréquence souhaitée et
- former un signal de commutation (117 : 317),

**caractérisé par** les étapes suivantes :

- en fonction d'un signal de sélection (121 : 321), sélection du premier signal de commande (113 : 313) ou du deuxième signal de commande (115, 118 : 315, 318) comme signal de commande (116 : 316) sélectionné,

- en mode de commande destiné à définir la fréquence souhaitée, fourniture d'un signal de sélection (121 : 321) qui a pour effet la sélection du deuxième signal de commande (115, 118 : 315, 318) comme signal de commande (116 : 316) sélectionné, et ensuite, après que le signal de commutation (117 : 317) a été formé, en mode de régulation, formation d'un signal de sélection (121 : 321) qui a pour effet la sélection du premier signal de commande (113 : 313) comme signal de commande (116 : 316) sélectionné,

- un tableau qui présente des paires fréquence - tension étant conservé dans une mémoire et présentant pour chaque valeur de fréquence d'une paire fréquence - tension une valeur de tension correspondante,

- en mode de commande, par lecture du tableau des paires fréquence - tension, formation du deuxième signal de commande (115, 118 : 315, 318) en fonction de la fréquence souhaitée,

- en mode de régulation, pour les fréquences réglées, renouvellement des paires fréquence - tension du tableau conservé en mémoire et

- formation du signal de commutation lorsque la différence entre le premier signal de commande (113 : 313) et le deuxième signal de commande (115, 118 : 315, 318) n'atteint pas une valeur de différence prédéterminée ou lorsqu'une condition d'enclenchement du circuit (400) de régulation de phase est détectée.

Fig. 1

EP 1 030 452 B1

*Fig. 2*

EP 1 030 452 B1

Fig. 3

*Fig. 4*

400

412

402

413

414

416

411

420

403   404   406   401

417

419   418

409   408

415

422

421

405

EP 1 030 452 B1

15

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19653134 A1
- US 5761258 A